## Europäisches Patentamt

(19) **European Patent Office**

**Office européen des brevets**

(11) Numéro de publication: **0 143 792**
**B1**

(12) # FASCICULE DE BREVET EUROPEEN

(45) Date de publication du fascicule du brevet:
**16.09.87**

(51) Int. Cl.⁴: **C 30 B 23/06,** C 23 C 14/28

(21) Numéro de dépôt: **84901081.4**

(22) Date de dépôt: **06.03.84**

(86) Numéro de dépôt international:
**PCT/FR 84/00052**

(87) Numéro de publication internationale:
**WO 84/03524 (13.09.84** Gazette **84/22)**

(54) **PROCEDE DE FORMATION D'UN FLUX D'ATOMES ET SON UTILISATION DANS UN PROCEDE ET UN DISPOSITIF D'EPITAXIE PAR JETS ATOMIQUES (E.J.A.).**

(30) Priorité: **07.03.83 FR 8303691**

(43) Date de publication de la demande:
**12.06.85 Bulletin 85/24**

(45) Mention de la délivrance du brevet:
**16.09.87 Bulletin 87/38**

(84) Etats contractants désignés:
**DE FR GB**

(56) Documents cités:
**Crystal Research & Technology, vol. 16, no. 8, 1981, Bad Langensalza (DD) R.N. Sheftal et al. "Mechanism of condensation of heteroeptaxial A3B5 layers deposited by a laser pulse of moderate power", pages 887-891, see page 890; cited in the application**
**Journal of Crystal Growth, vol. 56, no. 2, 1982, Amsterdam (NL) H.T. Yang et al. "Pulsed laser evaporated Sn02 films", see pages 429-432**
**Soviet Physics, Technical Physics, vol. 23, no. 5, May 1978, Yu. A. Bykovskii et al "Deposition of metal, semiconductor, and oxide films with a periodically pulsed C02 laser", see pages 578-581**

(73) Titulaire: **BENSOUSSAN, Marcel, 881 Cours Aquitaine, F-92100 Boulogne (FR)**
Titulaire: **MOISON, Jean-Marie, 8, Allée de la Belle Issue, F-78290 Croissy-sur-Seine (FR)**

(72) Inventeur: **BENSOUSSAN, Marcel, 881 Cours Aquitaine, F-92100 Boulogne (FR)**
Inventeur: **MOISON, Jean-Marie, 8, Allée de la Belle Issue, F-78290 Croissy-sur-Seine (FR)**

(74) Mandataire: **Mongrédien, André et al, c/o BREVATOME 25, rue de Ponthieu, F-75008 Paris (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention a pour objet un procédé de formation d'un flux d'atomes d'un élément, utilisable notamment dans un procédé et un dispositif de dépôt par épitaxie ou de dépôt sous ultra-vide, de couches à base de semiconducteurs III-V ou de leurs dérivés ternaires et quaternaires.

Depuis quelques années, le développement des composants pour l'optoélectronique et la microélectronique nécessite la réalisation de couches minces à base de semiconducteurs III-V ou de leurs dérivés ternaires et quaternaires. Généralement, on réalise de telles couches par épitaxie sur un substrat binaire et les techniques d'épitaxie utilisées actuellement sont l'épitaxie en phase liquide (LPE), l'épitaxie chimique en phase vapeur (CVD) et l'épitaxie par jets moléculaires (MBE). Parmi celles-ci, l'épitaxie par jets moléculaires présente des performances intrinsèquement plus élevées, notamment pour l'obtention de couches très minces ayant par exemple une épaisseur de quelques Å, qui soient par ailleurs très planes, aient une stoechiométrie variable dans de grandes proportions et présentent des interfaces très abruptes. Cependant, la mise en œuvre de cette technique de dépôt par épitaxie reste délicate et pose certains problèmes car il est difficile d'éviter une contamination de la couche et de contrôler avec précision l'incorporation des éléments dopants et des éléments du groupe V de la classification périodique des éléments.

Dans cette technique d'épitaxie, on forme les jets moléculaires de l'élément V, par exemple de P ou de As, soit en utilisant une cellule de Knudsen contenant l'élément massif ou un de ses composés, soit en utilisant des gaz décomposés «in situ» comme cela est décrit dans les documents: — S.L. Wright, and H. Kroemer, J. Vac. Sci. Technol. 20(2), 143 (1982); M.B. Panish, J. Electrochem. Soc. 127(12), 2729 (1981) et A.L. Calawa, Appl. Phys. Lett. 38(9), 701 (1981) — Dans de telles méthodes, l'élément du groupe III est amené sur le substrat sous la forme d'un jet atomique ou d'un jet moléculaire obtenu par chauffage d'un creuset contenant cet élément à l'état pur. De ce fait, ces méthodes présentent certains inconvénients dus soit à la complexité des équipements de croissance, soit à la présence de fours chauds dans l'enceinte de dépôt, ce qui crée une contamination difficile à contrôler. De plus, étant donné que certaines espèces chimiques sont amenées sur le substrat sous la forme de molécules alors que d'autres espèces sont amenées sous la forme d'atomes, la réaction superficielle du jet avec le substrat est complexe et souvent à l'origine d'un dopage involontaire ou de la création de centres profonds.

Pour le dépôt de couches de composé III-V tel que GaAs, on à également envisagé l'utilisation de lasers pulsés pour produire des films de GaAs à partir d'une cible de GaAs et d'une cible d'arsenic polycristallin, comme cela est décrit dans l'article: Crystal Research and Technology, vol. 16, n° 8 (1981), pages 887-891.

Cependant, dans les conditions décrites dans cet article, on ne peut obtenir un faisceau d'atomes de l'élément V et ceci ne permet pas d'éliminer les réactions complexes évoquées ci-dessus au niveau du substrat.

La présente invention a précisément pour objet un procédé de formation d'un flux d'atomes d'un élément, qui peut être utilisé notamment pour le dépôt de couches par épitaxie ou par dépôt sous ultravide afin d'éviter les inconvénients rappelés ci-dessus.

Le procédé, selon l'invention, de formation d'un flux d'atomes d'un élément se caractérise en ce qu'il consiste à irradier une cible constituée par un composé de cet élément au moyen d'un laser pulsé dont la densité d'énergie par impulsion est au moins égale au seuil d'émission d'atomes dudit élément et inférieur au seuil d'ablation dudit élément ou dudit composé.

Ainsi, en choisissant de façon appropriée l'énergie et la durée d'impulsions du laser utilisé, on peut extraire d'une cible constituée par un composé d'un élément un flux constitué essentiellement d'atomes de cet élément. On savait qu'en irradiant une cible solide par un faisceau laser de forte puissance, on obtenait une vaporisation à la surface de la cible et une désorption des atomes constituant celle-ci sous la forme de différents groupements d'atomes. Lorsqu'on irradie la cible au moyen d'un laser continu, on provoque un échauffement de la surface de la cible et les particules extraites de celle-ci sont équivalentes à celles qu'on obtiendrait avec un chauffage classique. En revanche, lorsqu'on utilise un laser pulsé, on développe dans la cible des gradients de températures énormes pendant des temps très courts, par exemple des montées et des descentes en température de $10^{10}$ à $10^{14}$ °K/s et en contrôlant de façon appropriée la densité d'énergie par impulsion du laser, on peut extraire l'élément ou un seul des éléments constituant la cible, sous la forme d'un faisceau d'atomes et/ou d'ions. De plus, avec un laser pulsé, des réactions spécifiques peuvent être induites car on peut dépasser de façon transitoire la densité d'énergie qui serait insupportable lors d'une irradiation en régime continu.

Avantageusement, on règle la durée des impulsions du laser pulsé à une valeur au plus égale à 1 µs.

Lorsque l'on irradie une cible de GaAs avec un laser pulsé dont la densité d'énergie se trouve au-delà du seuil supérieur d'ablation de l'élément, on obtient un faisceau comportant à la fois du gallium et de l'arsenic avec prédominance de gallium, et l'on peut compenser la perte en arsenic en utilisant une cible additionelle d'arsenic que l'on irradie par le même laser pulsé, comme cela est indiqué dans l'article de Crystal Research and Technology, vol. 16, n° 8, 1981.

Aussi, selon l'invention, on utilise des densités d'énergie par impulsion plus faibles de façon à rester dans un régime où l'on émet uniquement des atomes de l'un des éléments du composé formant la cible et où l'on éjecte ces atomes avant leur regroupement en molécules.

On précise que le seuil d'ablation de l'élément ou du composé de l'élément constituant la cible correspond à l'émission de différentes espèces (atomes, molécules et/ou ions) à partir de la cible.

Selon un mode préféré de réalisation de l'invention, l'élément est un élément du groupe V de la Classification Périodique des Eléments et la cible est constituée par un composé binaire de cet élément du type III-V.

Lorsque l'élément est le phosphore, la cible peut être réalisée en InP ou GaP.

Lorsque l'élément est l'arsenic, la cible peut être réalisée en GaAs.

Comme on l'a vu précédemment, la densité d'énergie par impulsion doit être au moins égale au seuil d'émission d'atomes de l'élément V et rester inférieure au seuil d'ablation de l'élément V ou du composé de l'élément V. Ces seuils dépendent de la nature de la cible utilisée. Par exemple, lorsque l'on utilise une cible en InP, le seuil inférieur d'émission d'atomes de phosphore à partir de cette cible est de $0,2$ J/cm$^2$ et le seuil supérieur d'ablation se situe à une valeur d'environ $1,6$ J/cm$^2$.

Dans le cas d'une cible en GaAs, le seuil inférieur d'émission d'atomes d'arsenic est de $0,5$ J/cm$^2$ et le seuil supérieur d'ablation se situe à une valeur d'environ $1,8$ J/cm$^2$.

Ainsi, selon l'invention, on règle la densité d'énergie par impulsion du laser pulsé à une valeur comprise entre ces deux seuils, et le choix de cette valeur dépend de la vitesse de croissance que l'on veut obtenir.

En effet, la densité d'énergie du laser influe sur la vitesse de vaporisation de la cible. Ainsi, dans le cas d'une cible en InP, on a une vitesse de vaporisation de $5 \cdot 10^{13}$ atomes de phosphore/cm$^2 \cdot$ s pour une densité d'énergie par impulsion de $0,3$ J/cm$^2$.

Les lasers pulsés susceptibles d'être utilisés peuvent être de nature très variée. A titre d'exemple, on peut citer les lasers à YAG, à YAG doublé, à rubis, etc... et les lasers U.V.

Ainsi, en utilisant, par exemple, un laser pulsé fournissant des impulsions de l'ordre de $0,3$ J/cm$^2$ pendant quelques nanosecondes, on peut obtenir un flux atomique d'un élément du groupe V de la Classification Périodique des Eléments, par irradiation d'une cible constituée d'un composé III-V de cet élément.

L'invention a également pour objet un procédé de dépôt par épitaxie d'une couche isolante, semiconductrice ou métallique d'un élément, ou d'un composé binaire, ternaire ou quaternaire de cet élément eventuellement dopé, par exemple d'un composé semiconducteur du type III-V tel que InP, GaP, GaAs, d'un métal ou d'un composé isolant.

Ce procédé consiste à faire croître sur un substrat chauffé une couche épitaxiée dudit élément ou dudit composé à partir d'un ou plusieurs flux d'atomes dont l'un au moins d'entre eux est engendré par irradiation d'une cible constituée par un composé dudit élément au moyen d'un laser pulsé dont la densité d'énergie par impulsion est au moins égale au seuil d'émission d'atomes dudit élément et inférieure au seuil d'ablation dudit élément ou dudit composé.

Lorsque la couche à déposer est une couche d'un composé binaire du type III-V ou de l'un de ses dérivés ternaires ou quaternaires, on forme le flux d'atomes de l'élément V par irradiation au moyen d'un laser pulsé d'une cible d'un composé III-V en utilisant une densité d'énergie par impulsion au moins égale au seuil d'émission d'atomes de l'élément V et inférieure au seuil d'ablation de l'élément V ou du composé de l'élément V. On peut aussi former le flux d'atomes de l'élément III par irradiation d'une cible constituée par l'élément III au moyen d'un laser pulsé.

Cependant, on peut utiliser l'irradiation laser uniquement pour former le flux d'atomes de l'élément V et former le flux d'atomes de l'élément III par des procédés classiques, par exemple en utilisant une cellule d'évaporation.

Le fait d'utiliser pour l'épitaxie, des jets atomiques au lieu de jets moléculaires, conduit à un certain nombre d'avantages.

Tout d'abord, les flux atomiques sont très réactifs et posent moins de problèmes pour leur incorporation au substrat.

Par ailleurs, le fait d'utiliser un laser pulsé évite les problèmes de contamination dus au chauffage des cibles ou des creusets d'évaporation par des moyens classiques. En effet, lorsqu'on utilise un laser pulsé, le substrat devient le point le plus chaud de l'enceinte de dépôt et on peut simplifier de ce fait les protections thermiques et les systèmes de pompage. On évite également la contamination du creuset qui est généralement en contact avec la source et, étant donné que la source reste froide pendant l'évaporation, on élimine les problèmes de corrosion, d'alliage ou de dégazage du creuset. On peut obtenir de plus, un contrôle aisé et rapide du flux par simple action sur le faisceau laser, et les problèmes de mise en température et en équilibre des creusets contenant les cibles sont également éliminés, ce qui permet d'obtenir un gain de temps non négligeable.

Enfin, le procédé d'épitaxie par jets atomiques permet un contrôle de l'épaisseur du dépôt à l'échelle d'une monocouche comme dans les procédés d'épitaxie par jets moléculaires.

Selon l'invention, on peut aussi introduire dans la couche épitaxiée un élément dopant en dirigeant sur le substrat chauffé un faisceau d'atomes ou d'ions de cet élément dopant formé par irradiation d'une cible de cet élément ou d'un composé de cet élément au moyen d'un laser pulsé.

Dans ce cas, si l'on veut utiliser uniquement un faisceau ionique, on peut isoler les ions émis en utilisant des moyens pour dévier et éventuellement accélérer les ions du faisceau extrait de la cible par irradiation au moyen du laser pulsé.

En effet, lors de l'irradiation de la cible par un laser pulsé, le faisceau extrait contient une partie non négligeable d'ions, qui représente environ $1/1000$ è du flux observé et l'on peut isoler ceux-ci en utilisant des champs électriques appropriés pour obtenir ainsi une source d'éléments dopants.

Comme on peut déposer également en utilisant un laser pulsé une couche d'un métal ou d'un isolant, il est possible de réaliser dans le même ensemble un composant discret nécessitant la superposition de plusieurs couches de nature différente ou même un circuit intégré.

L'invention a aussi pour objet un dispositif d'épitaxie par jets atomiques, caractérisé en ce qu'il comprend:

— une enceinte étanche comportant des moyens pour supporter un substrat à épitaxier, des moyens pour chauffer le substrat et des moyens pour supporter une série de cibles des éléments et/ou de composés des éléments qui devront constituer la couche épitaxiée,

– un laser pulsé,

– des moyens pour diriger et focaliser le faisceau du laser pulsé sur au moins l'une des cibles situées dans l'enceinte,

– des moyens de chauffage desdites cibles pour assurer leur régénération, et

– des moyens additionnels de chauffage de certaines zones du substrat constitués par un laser pulsé.

En effet, après irradiation par un laser pulsé, les surfaces des cibles constituées par un composé binaire se sont enrichies en l'un des éléments du composé et il est nécessaire de les régénérer pour pouvoir poursuivre le dépôt. Or, ceci peut être réalisé par chauffage des cibles à des températures modérées de l'ordre de 100°C.

De préférence, les moyens de chauffage du substrat comprennent un laser.

Le dispositif de l'invention présente en particulier l'avantage de permettre l'émission simultanée de plusieurs faisceaux atomiques des différents éléments qui constitueront la couche épitaxiée.

En effet, en utilisant des moyens de commande et des moyens de déflexion appropriés, on peut utiliser un seul laser pulsé de forte puissance focalisé et balayé sur les différentes cibles afin d'obtenir ainsi des flux simultanés de plusieurs éléments. L'intensité des flux peut être imposée soit par une modulation de l'intensité laser, soit par modulation du temps passé sur chaque cible. Ainsi, le dispositif de dépôt par épitaxie de l'invention est beaucoup moins complexe que les dispositifs d'épitaxie par jets moléculaires; il peut par ailleurs présenter une taille inférieure et l'on peut utiliser successivement le même laser sur plusieurs enceintes de dépôt. On peut aussi utiliser le laser pour réaliser des opérations préliminaires de nettoyage du substrat. Le dispositif de l'invention présente de plus une propriété et une souplesse inhérentes, ce qui permet d'accroître la qualité et la définition des couches déposées qui peuvent être de nature très variée.

Selon l'invention, on peut aussi réaliser une épitaxie sélective ou une variation latérale de la composition de la couche en cours de croissance en modulant le chauffage de la surface du substrat au moyen d'un faisceau d'énergie tel qu'un faisceau d'électrons ou un faisceau laser, de manière à obtenir une modulation de la température à la surface du substrat. Ainsi, selon un mode particulier de réalisation du procédé d'épitaxie de l'invention, on chauffe le substrat au moyen d'un faisceau d'énergie de façon telle que l'on obtienne une modulation de la température sur la surface du substrat, certaines zones du substrat étant portées à une température T et les autres zones du substrat étant portées à une température T + ΔT. Selon les besoins, la température T peut être réalisée en chauffant le substrat par un chauffage classique.

On peut obtenir cette modulation de la température en formant sur la surface du substrat à partir dudit faisceau, une figure d'interférence, une figure de diffraction ou l'image d'un masque.

On peut aussi obtenir cette modulation de la température en déplaçant ledit faisceau sur la surface du substrat et en modulant la puissance dudit faisceau de façon synchrone au déplacement. Dans ce cas, il faut, toutefois, que la vitesse de déplacement du faisceau soit plus grande que la vitesse de diffusion thermique.

Selon l'invention, l'écart de température $\Delta T$ est déterminé pour obtenir, soit un dépôt sélectif, soit une variation de la composition de la couche sur la surface du substrat.

Dans le premier cas, l'écart de température $\Delta T$ est tel que la température $T + \Delta T$ corresponde à une vitesse de croissance nulle de la couche épitaxiée.

En effet, on rappelle que lors de l'épitaxie, on envoie sur le substrat chauffé un flux d'atomes ou de molécules $J_0$ et on porte le substrat à une température élevée, par exemple de l'ordre de 600°C dans le cas d'un substrat en GaAs. Dans ces conditions, il se produit une désorption thermique sur le substrat avec un flux $J_1$ qui dépend de la température T à laquelle est porté le substrat. La vitesse de croissance V est proportionelle à $(J_0-J_1)$ et dépend ainsi de T. Ainsi, pour des températures élevées, $J_1$ peut prendre une valeur supérieure à $J_0$ et la vitesse de croissance peut devenir négative. Si l'on module T, on module $J_1$ et par conséquent la vitesse de croissance V.

Aussi, lorsqu'on veut réaliser sur le substrat une épitaxie sélective, c'est-à-dire déposer la couche épitaxiée seulement sur certaines zones du substrat, il suffit que la température sur les zones du substrat qui ne devront pas comporter de couches soit supérieure et corresponde à une vitesse de croissance nulle.

On peut aussi choisir l'écart de température $\Delta T$ de façon à obtenir une composition différente de la couche sur les zones chauffées à la température $T + \Delta T$ et sur les zones chauffées à la température T.

En effet, lors de la croissance d'un composé binaire, ternaire ou quaternaire, le comportement de la couche épitaxiée dépend de façon critique de la température à la surface du substrat, et ceci dans des plages très étroites de températures, en raison du fait que la désorption thermique des constituants de la couche ne se produit pas aux mêmes températures. Par conséquent, on peut choisir une température pour laquelle la désorption de l'un des constituants de la couche est plus élevée, ce qui conduit à l'appauvrissement de la couche en ce constituant.

Ainsi, lors du dépôt par épitaxie de GaAlAs sur un substrat en GaAs, la désorption thermique de Ga se produit à des températures plus basses que celles de Al et une augmentation de température conduit donc à un appauvrissement en Ga de la couche déposée. Il en est de même lors du dépôt par épitaxie d'une couche de InAlAs.

Aussi, une modulation bien contrôlée de la température à la surface du substrat conduit à une modulation de la composition de la couche en cours d'épitaxie.

Dans tous les cas, la modulation de température sur la surface du substrat peut être obtenue au moyen d'un laser continu ou d'un laser pulsé.

Lorsqu'on utilise un laser continu pour chauffer le substrat, on peut obtenir cette différence de température en modulant l'éclairement de la surface du substrat en fonction des motifs que l'on veut obtenir.

Par exemple, lorsque les motifs épitaxiés doivent reproduire un réseau de pas $x_0$, on peut chauffer le substrat de manière classique à la température $T_0$ et imposer une modulation supplémentaire de température de période $x_0$ et d'amplitude $\Delta T$ suffisante pour réaliser la croissance selon le motif recherché, ce qui revient à moduler la puissance du laser continu déposé sur le substrat avec la période $x_0$ par un dispositif optique en réalisant par exemple une figure d'interférence ou de diffraction ou par un masque pour que cette puissance varie de la façon suivante:

$$P = P_{max.} \cos 2\pi \cdot \frac{x}{x_0}$$

Dans le cas d'un laser continu, à l'équilibre thermique et dans un modèle simple, la modulation de températures $\Delta T$ correspond sensiblement à:

$$P_{max.} \cdot \frac{\alpha x_0^2}{4\pi^2 K}$$

avec $\alpha$ représentant le coefficient d'absorption de la lumière et $K$ la conductivité thermique du substrat.

Si l'on prend par exemple le cas d'un substrat de GaAs, on a $\alpha = 10^5$ cm$^{-1}$ et $K = 0,13$ W · cm$^{-1}$ · K$^{-1}$.

Aussi, si l'on veut obtenir une résolution de 10 $\mu$m, la différence de températures $\Delta T(K)$ entre les différentes zones du substrat doit être de 0,02 $\Delta P(W)$. Dans le cas d'un substrat de GaAs, où $\Delta T$ doit être d'environ 40°K et T de 670°C pour annuler complètement la croissance sur les zones du substrat chauffées à la température supérieure de 710°C, la différence de puissance $\Delta P$ du laser doit être supérieure à $5 \cdot 10^3$ W/cm$^2$.

Ceci peut être obtenu, mais on se trouve à la limite de seuil de dommage optique du substrat en GaAs puisque ce seuil est de l'ordre de $10^4$ W/cm$^2$. Aussi, si l'on utilise un laser continu, on doit limiter le pas du réseau à 3 $\mu$m pour ne pas dépasser le seuil de $10^4$ W/cm$^2$.

En revanche, si l'on utilise un laser pulsé non seulement pour le chauffage du substrat mais aussi de manière synchrone pour former des faisceaux d'atomes des éléments de la couche à épitaxier, l'équilibre thermique par diffusion de la chaleur des zones plus chaudes aux zones plus froides n'a pas le temps de se faire pendant le dépôt si la durée de dépôt et de chauffage t est inférieure à $x_0^2/D$ où D représente la diffusivité thermique et $x_0$ le pas du réseau. Dans ces conditions, la modulation de température est alors directement proportionelle à la modulation de densité d'energie F (J/cm$^2$) et $\Delta T$ est égal à $\Delta F \cdot \dfrac{D\alpha}{K}$.

Pour GaAs, on a $\alpha = 10^5$ cm$^{-1}$, $K = 0,13$ W · cm$^{-1}$ · K$^{-1}$ et $D = 0,05$ cm$^2$/s.

Dans ces conditions, pour obtenir une modulation de températures de 40°, il faut que la modulation de densité d'énergie du laser soit de $10^{-3}$ J/cm$^2$. Ceci est 100 fois inférieur au seuil de dommage optique du substrat (0,1 J/cm$^2$) et l'on obtient donc plus facilement la modulation de température en utilisant un laser pulsé plutôt qu'un laser continu.

De plus, la seule limitation sur le pas du réseau $x_0$ est que $x_0$ soit inférieur à $\sqrt{D \cdot t}$. Si l'on utilise une source rapide, t est sensiblement de $10^{-8}$ s, $x_0$ peut ainsi atteindre 0,3 $\mu$m, ce qui constitue la limite de l'optique géométrique pour des lasers courants.

Ainsi, on peut obtenir une résolution bien meilleure en utilisant un laser pulsé couplé à une source pulsée.

Dans le cas où l'on veut moduler la composition d'une couche de GaAlAs depuis $Ga_{1-y}Al_yAs$ jusqu'à $Ga_{1-y-0,1}Al_{y+0,1}As$, selon un réseau de pas $x_0 = 10$ $\mu$m, la différence de température $\Delta T$ doit être de 5° au-dessus de T = 690°C. Ainsi, le $\Delta T$ nécessaire est assez petit pour qu'on ne module pas simultanément de beaucoup la vitesse de croissance. Dans ce cas, si l'on utilse un laser continu, la différence de puissance $\Delta P$ du laser doit être supérieure à $2 \cdot 10^2$ W/cm$^2$.

Pour un laser continu pour ne pas dépasser le seuil de dommage optique qui est de $10^4$ W/cm$^2$ on doit limiter le pas à 0,7 $\mu$m.

Si l'on utilise un laser pulsé, la modulation d'énergie du laser doit être de $1,5 \cdot 10^{-4}$ J/cm$^2$, ce qui est 800 fois supérieur au seuil de dommage optique du substrat (0,1 J/cm$^2$). Ainsi, comme on l'a vu précédemment, on peut obtenir une meilleure résolution en utilisant un laser pulsé.

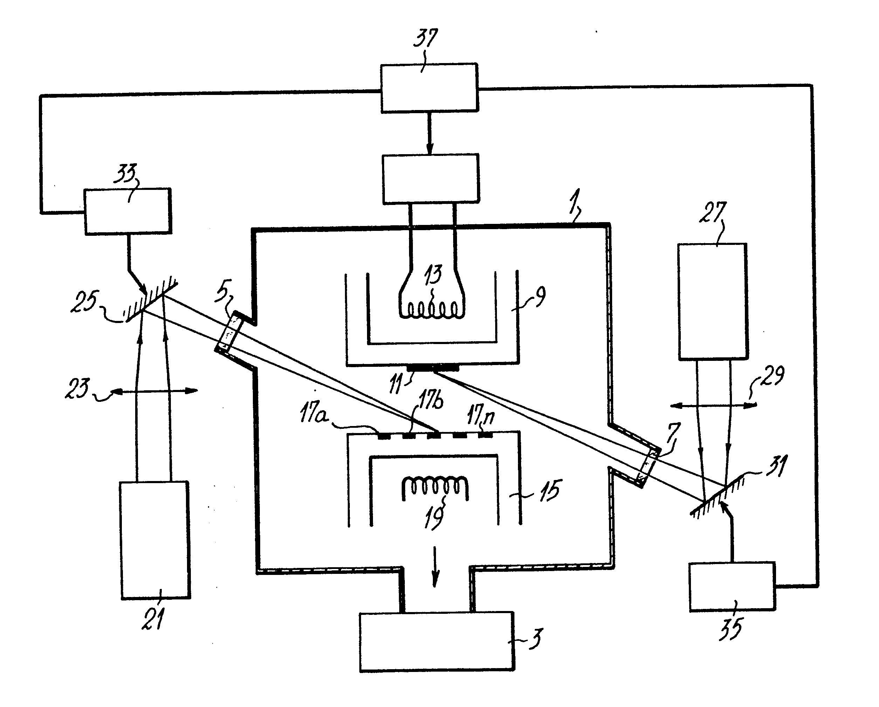

D'autres caractéristiques et avantages de l'invention apparaîtront mieux à la lecture de la description qui suit, donnée bien entendu à titre illustratif et non limitatif, en référence au dessin annexé qui représente un dispositif d'épitaxie selon l'invention.

Sur cette figure, on voit que le dispositif d'épitaxie comprend une enceinte étanche 1 qui peut être mise sous vide grâce aux moyens de pompage 3. Cette enceinte est munie d'un premier hublot 5 et d'un second hublot 7 transparents. A l'intérieur de l'enceinte, un support 9 est destiné à recevoir le substrat 11 à épitaxier. Ce substrat 11 peut être porté à la température appropriée par les moyens de chauffage 13.

En regard du substrat 11, un second support 15 est destiné à recevoir une pluralité de cibles 17a, 17b,... 17n et ces cibles peuvent être chauffées par un moyen de chauffage 19. A l'extérieur de l'enceinte, un premier laser pulsé 21 dont le faisceau peut être focalisé et dirigé sur les cibles 17a, 17b,... 17n est destiné à la formation des faisceaux d'atomes nécessaires à l'épitaxie. Dans ce but, le laser pulsé 21 est associé à une lentille 23 et à un miroir 25 dont l'orientation peut être modifiée selon un programme approprié afin de diriger le faisceau sur les cibles 17a, 17b,... 17n et de balayer successivement la surface d'une ou plusieurs de ces cibles.

Le dispositif peut comporter également un second laser 27 qui peut être un laser pulsé ou un laser continu, et qui est destiné à assurer le chauffage du substrat 11. De même, ce laser est associé à une lentille 29 et à un miroir 31 dont l'orientation peut être modifiée en fonction du temps pour diriger le faisceau du laser à travers le hublot 7 sur le substrat 11 et balayer la surface de ce substrat.

Les moyens de commande respectifs 33 et 35 des miroirs 25 et 31 peuvent être programmés par un ordinateur ou un microprocesseur 37. De même, on peut utiliser un microprocesseur pour programmer le four de chauffage 13 du substrat et le miroir 25.

Dans un dispositif de ce type, on peut réaliser le dépôt d'une couche épitaxiée de GaAs en utilisant des cibles réalisées en gallium et en GaAs et un laser pulsé focalisé sur une surface S de 1 cm$^2$, ayant une densité d'énergie par impulsion de 1 J/cm$^2$, une durée d'impulsions de 20 nanosecondes et une fréquence d'impulsions f de 10 Hz, la distance d entre le substrat 11 et les cibles 17 étant de 1 cm.

Dans ces conditions, la densité d'atomes d'arsenic émis à chaque impulsion est de 10$^{14}$ atomes d'arsenic par cm$^2$. Or la vitesse de croissance V (cm · s$^{-1}$) est égale à D · S · f/πd$^2$N avec N représentant le nombre d'atomes par cm$^3$ dans le film qui est de 2,2 · 10$^{22}$ cm$^{-3}$ pour GaAs.

Ainsi, on obtient une vitesse de croissance égale à 1,5 · 10$^{-8}$ cm/s soit 0,5 μm/h, ce qui est tout à fait comparable à ce que l'on obtient en réalisant l'épitaxie par jets moléculaires.

Pour obtenir cette croissance, on fait tout d'abord le vide dans l'enceinte 1 pour atteindre environ 10$^{-10}$ torr, on met en marche le moyen de chauffage 13 pour porter le substrat de GaAs à la température d'environ 600°C et on règle le laser 21, de façon à ce qu'il balaye la cible de GaAs et la cible de gallium avec des impulsions de fréquence et d'énergie voulues pour extraire simultanément un faisceau d'atomes d'arsenic et un faisceau d'atomes de gallium. Ainsi, on fait croître sur le substrat 11 une couche de GaAs.

Ce dispositif peut être utilisé également pour la croissance épitaxiale de InP. Dans ces conditions, la cible de phosphore est constituée par un monocristal de InP (100) et l'on utilise un laser pulsé à colorant ayant une longueur d'onde voisine de 5400 Å et une énergie d'environ 2,3 eV. On focalise le faisceau du laser de manière à obtenir des puissances de crêtes d'environ 200 MW/cm$^2$ avec une durée d'impulsion de 5 nanosecondes et une fréquence de 20 Hz, soit une densité d'énergie par impulsion de 1J/cm$^2$. Dans ces conditions, on obtient un flux constitué d'au moins 95% par du phosphore atomique et l'on peut obtenir un taux de désorption correspondant au départ de 10 monocouches à la seconde, soit une vitesse de désorption de 10 μm/h.

La procédure de croissance est la même que celle décrite précédemment pour GaAs sauf qu'ici le substrat de InP est porté à une température d'environ 300°C ou à une température d'environ 500°C en présence d'une atmosphère de phosphore ou d'arsenic.

Dans tous les cas, après irradiation des cibles, on soumet ces dernières à un chauffage à environ 100°C pour régénérer la surface des cibles en InP ou GaAs. En effet, après irradiation et départ du phosphore ou de l'arsenic, la surface est fortement enrichie en indium ou en gallium.

Cependant, un chauffage ultérieur à 100°C rassemble cet excès d'indium ou de gallium en îlots macroscopiques, la surface entre les îlots étant identique à la surface de départ, ce qui suffit donc à régénérer la cible.

## Revendications

1. Procédé de formation d'un flux d'atomes d'un élément, caractérisé en ce qu'il consiste à irradier une cible constituée par un composé de cet élément au moyen d'un laser pulsé dont la densité d'énergie par impulsion est au moins égale au seuil d'émission d'atomes dudit élément et inférieure au seuil d'ablation dudit élément ou dudit composé.

2. Procédé selon la revendication 1, caractérisé en ce que l'on règle la durée d'impulsion dudit laser pulsé à une valeur au plus égale à 1 microseconde.

3. Procédé selon l'une quelconque des revendications 1 et 2, caractérisé en ce que l'élément est un élément du groupe V de la Classification Périodique des Eléments et en ce que la cible est constituée par un composé binaire du type III-V.

4. Procédé selon la revendication 3, caractérisé en ce que ledit élément est le phosphore.

5. Procédé selon la revendication 5, caractérisé en ce que la cible est réalisée en InP.

6. Procédé selon la revendication 4, caractérisé en ce que la cible est réalisée en GaP.

7. Procédé selon la revendication 3, caractérisé en ce que l'élément est l'arsenic.

8. Procédé selon la revendication 7, caractérisé en ce que la cible est constituée de GaAs.

9. Procédé de dépôt par épitaxie d'une couche isolante, semiconductrice ou métallique, d'un élément ou d'un composé binaire, ternaire ou quaternaire de cet élément éventuellement dopé, caractérisé en ce qu'il consiste à faire croître sur un substrat chauffé une couche épitaxiée dudit élément ou dudit composé à partir d'un ou du plusieurs flux d'atomes dont l'un au moins d'entre eux est engendré par irradiation d'une cible constituée par un composé dudit élément selon le procédé de la revendication 1.

10. Procédé selon la revendication 9, caractérisé en ce que la couche semiconductrice épitaxiée étant une couche à base d'un semiconducteur III-V ou de l'un de ses dérivés ternaires ou quaternaires, on forme le flux d'atomes de l'élément V par le procédé selon l'une quelconque des revendications 3 à 8.

11. Procédé selon la revendication 10, caractérisé en ce que l'on forme un flux d'atomes de l'élément III par irradiation d'une cible de l'élément III au moyen d'un laser pulsé.

12. Procédé selon l'une quelconque des revendications 9 à 11, caractérisé en ce que l'on introduit un élément dopant dans la couche épitaxiée, en dirigeant sur le substrat chauffé un faisceau d'atomes et/ou d'ions de cet élément dopant formé par irradiation d'une cible de cet élément ou d'un composé de cet élément au moyen d'un laser pulsé.

13. Procédé selon l'une quelconque des revendications 9 à 12, caractérisé en ce que l'on chauffe le substrat au moyen d'un faisceau d'énergie de façon telle que l'on obtienne une modulation de la température sur la surface du substrat, certaines zones du substrat étant portées à une température T et les autres zones du substrat portées à une température T + ΔT.

14. Procédé selon la revendication 13, caractérisé en ce que l'on obtient cette modulation de la température en formant sur la surface du substrat, à partir dudit faisceau, une figure d'interférence, une figure de diffraction ou l'image d'un masque.

15. Procédé selon la revendication 13, caractérisé en ce que l'on obtient cette modulation de la température en déplaçant ledit faisceau sur la surface dudit substrat et en modulant la puissance dudit faisceau de façon synchrone au déplacement.

16. Procédé selon la revendication 13, caractérisé en ce que l'écart de température $\Delta T$ est tel que la température $T + \Delta T$ corresponde à une vitesse de croissance nulle de la couche épitaxiée.

17. Procédé selon la revendication 13, caractérisé en ce que l'écart de température $\Delta T$ est tel que la composition de la couche soit différente sur les zones chauffées à la température $T + \Delta T$ et sur les zones chauffées à la température $T$.

18. Procédé selon l'une quelconque des revendications 13 à 17, caractérisé en ce que ledit faisceau est constitué par un laser pulsé.

19. Dispositif d'épitaxie pour la mise en œuvre du procédé selon la revendication 13, caractérisé en ce qu'il comprend:
- une enceinte étanche (1) comportant des moyens (9) pour supporter un substrat (11) à épitaxier, des moyens (13) pour chauffer le substrat et des moyens (15) pour supporter une série de cibles (17) des éléments et/ou de composés des éléments qui devront constituer la couche épitaxiée,
- un laser pulsé (21),
- des moyens (25, 23) pour diriger et focaliser le faisceau du laser pulsé sur au moins l'une des cibles (17) situées dans l'enceinte,
- des moyens de chauffage (19) desdites cibles, et
- des moyens additionnels de chauffage de certaines zones du substrat constitués par un laser pulsé (27).

**Patentansprüche**

1. Verfahren zum Formen eines Flusses von Atomen eines Elementes, dadurch gekennzeichnet, dass es darin besteht, ein von einer Verbindung dieses Elements gebildetes Target mit einem gepulsten Laser zu bestrahlen, dessen Energiedichte pro Impuls mindestens gleich der Emmissionsschwelle der Atome dieses Elements und kleiner als die Ablationsschwelle dieses Elements oder dieser Verbindung ist.

2. Verfahren nach Anspruch 1, dadurch gekennzeichnet, dass man die Impulsdauer des gepulsten Lasers auf einen Wert von höchstens gleich einer Mikrosekunde einstellt.

3. Verfahren nach Anspruch 1 oder 2, dadurch gekennzeichnet, dass das Element ein Element der Gruppe C des Periodensystems der Elemente ist und dass das Target von einer binären Verbindung von der Art III-V gebildet wird.

4. Verfahren nach Anspruch 3, dadurch gekennzeichnet, dass das Element Phosphor ist.

5. Verfahren nach Anspruch 4, dadurch gekennzeichnet, dass das Target aus InP hergestellt ist.

6. Verfahren nach Anspruch 4, dadurch gekennzeichnet, dass das Target aus GaP hergestellt ist.

7. Verfahren nach Anspruch 3, dadurch gekennzeichnet, dass das Element Arsen ist.

8. Verfahren nach Anspruch 7, dadurch gekennzeichnet, dass das Target von GaAs gebildet wird.

9. Verfahren zum Aufbringen einer isolierenden, halbleitenden oder metallischen Schicht eines Elements oder einer gegebenenfalls dotierten, binären, ternären oder quaternären Verbindung dieses Elements durch Aufwachsen, dadurch gekennzeichnet, dass es darin besteht, dass man auf einem erwärmten Substrat eine Aufwachsungsschicht des Elements oder der Verbindung ausgehend von einem Atomfluss oder mehreren Atomflüssen aufwachsen lässt, von denen wenigstens einer durch Bestrahlung eines von einer Verbindung des Elements gebildeten Targets gemäss dem Verfahren nach Anspruch 1 erzeugt wird.

10. Verfahren nach Anspruch 9, dadurch gekennzeichnet, dass die aufgewachsene, halbleitende Schicht eine Schicht auf der Basis eines III-V-Halbleiters oder eines seiner ternären oder quaternären Verbindungen ist, wobei der Fluss der Atome des Elements V durch das Verfahren nach einem der Ansprüche 3 bis 8 gebildet wird.

11. Verfahren nach Anspruch 10, dadurch gekennzeichnet, dass man einen Fluss von Atomen des Elements III durch Bestrahlung eines Targets des Elements III mit einem gepulsten Laser bildet.

12. Verfahren nach einem der Ansprüche 9 bis 11, dadurch gekennzeichnet, dass man ein dotiertes Element in die aufgewachsene Schicht einbringt, indem man auf das gewärmte Substrat ein Bündel von Atomen und/oder Ionen dieses Dotierelements lenkt, welches durch Bestrahlung eines Targets dieses Elements oder einer Verbindung dieses Elements mit einem gepulsten Laser bildet.

13. Verfahren nach einem der Ansprüche 9 bis 12, dadurch gekennzeichnet, dass man das Substrat mittels eines Energiebündels derart erwärmt, dass man eine Temperaturmodulation an der Substratoberfläche erhält, wobei gewisse Bereiche des Substrats auf eine Temperatur $T$ und andere Bereiche des Substrats auf eine Temperatur $T + \Delta T$ gebracht werden.

14. Verfahren nach Anspruch 13, dadurch gekennzeichnet, dass man diese Temperaturmodulation erhält, indem man an der Oberfläche des Substrats ausgehend von dem Bündel ein Interferenzmuster, ein Beugungsmuster oder das Bild einer Maske bildet.

15. Verfahren nach Anspruch 13, dadurch gekennzeichnet, dass man diese Temperaturmodulation erhält, indem man das Bündel auf der Oberfläche des Substrats bewegt und die Leistung des Bündels synchron mit der Bewegung moduliert.

16. Verfahren nach Anspruch 13, dadurch gekennzeichnet, dass der Temperaturabstand $\Delta T$ derart ist, dass die Temperatur $T + \Delta T$ einer Wachstumsgeschwindigkeit von Null der aufgewachsenen Schicht entspricht.

17. Verfahren nach Anspruch 13, dadurch gekennzeichnet, dass der Temperaturunterschied $\Delta T$ derart ist, dass die Zusammensetzung der Schicht auf den auf die Temperatur $T + \Delta T$ erwärmten Bereichen und den auf die Temperatur $T$ erwärmten Bereichen unterschiedlich ist.

18. Verfahren nach einem der Ansprüche 13 bis

7

17, dadurch gekennzeichnet, dass das Bündel von einem gepulsten Laser gebildet wird.

19. Vorrichtung zum Aufwachsen zur Durchführung des Verfahrens nach Anspruch 13, dadurch gekennzeichnet, dass sie umfasst:

- eine dichte Kammer (1) mit Mitteln (9) zum Halten eines Substrats (11), auf dem aufgewachsen werden soll, Mitteln (13) zum Erwärmen des Substrats und Mitteln (15) zum Tragen einer Reihe von Targets (17) der Elemente und/oder von Verbindungen der Elemente, die die aufgewachsene Schicht bilden sollen,
- einen gepulsten Laser (21),
- Mittel (25, 23), um das Bündel des gepulsten Lasters auf wenigstens eines der sich in der Kammer befindenden Targets (17) zu richten und zu fokussieren,
- Mittel (19) zum Erwärmen der Targets und
- weitere Mittel zum Erwärmen gewisser Bereiche des Substrats, die von einem gepulsten Laser (27) gebildet sind.

**Claims**

1. Process for forming a stream of atoms of an element, characterized in that it consists in irradiating a target consisting of a compound of this element using a pulsed laser whose energy density per pulse is at least equal to the emission threshold of atoms of the said element and lower than the ablation threshold of the said element or of the said compound.

2. Process according to claim 1, characterized in that the pulse duration of the said pulsed laser is regulated at a value not exceeding 1 microsecond.

3. Process according to either of claims 1 and 2, characterized in that the element is an element of group V of the Periodic Classification of the Elements and in that the target consists of a binary compound of the III-V type.

4. Process according to claim 3, characterized in that the said element is phosphorus.

5. Process according to claim 4, characterized in that the target is made of InP.

6. Process according to claim 4, characterized in that the target is made of GaP.

7. Process according to claim 3, characterized in that the element is arsenic.

8. Process according to claim 7, characterized in that target is made of GaAs.

9. Process for epitaxial deposition of a semiconductive or metallic insulating layer of an element or of a binary, ternary or quaternary compound of this element, optionally doped, characterized in that it consists of growing an epitaxial layer of the said element or of the said compound on a heated substrate, using one or more streams of atoms, at least one of which is generated by irradiating a target consisting of a compound of the said element according to the process of claim 1.

10. Process according to claim 9, characterized in that, with the epitaxial semiconductive layer being a layer on a III-V semiconductor or one of its ternary or quaternary derivatives, the stream of atoms of the V element is formed using the process according to any one of claims 3 to 8.

11. Process according to claim 10, characterized in that a stream of atoms of the III element is formed by irradiating a target of the III element using a pulsed laser.

12. Process according to any one of claims 9 to 11, characterized in that a dopant element is introduced into the epitaxially formed layer, by directing onto the geated substrate a beam of atoms and/or of ions of this dopant element formed by irradiating a target of this element or of a compound of this element using a pulsed laser.

13. Process according to any one of claims 9 to 12, characterized in that the substrate is heated by means of an energy beam in such manner that a modulation of the temperature is produced on the surface of the substrate, some regions of the substrate being raised to a temperature $T$ and other regions of the substrate being raised to a temperature $T + \Delta T$.

14. Process according to claim 13, characterized in that this temperature modulation is produced by forming an interference pattern, a diffraction pattern or the image of a mask on the surface of the substrate, using the said beam.

15. Process according to claim 13, characterized in that this temperature modulation is produced by moving the said beam over the surface of the said substrate and by modulating the power of the said beam synchronously with the movement.

16. Process according to claim 13, characterized in that the temperature difference $\Delta T$ is such that the temperature $T + \Delta T$ corresponds to a zero rate of growth of the epitaxial layer.

17. Process according to claim 13, characterized in that the temperature difference $\Delta T$ is such that the composition of the layer is different in the regions heated to the temperature $T + \Delta T$ and in the regions heated to the temperature $T$.

18. Process according to any one of claims 13 to 17, characterized in that the said beam consists of a pulsed laser.

19. Epitaxy device for implementing the process according to claim 13, characterized in that it comprises:

- a leakproof enclosure (1) comprising means (9) for supporting a substrate (11) to be treated epitaxially, means (13) for heating the substrate and means (15) for supporting a series of targets (17) of the elements and/or compounds of the elements which are to form the epitaxially formed layer,
- a pulsed laser (21),
- means (25, 23) for directing and focusing the pulsed laser beam, onto at least one of the targets (17) situated in the enclosure,
- means for heating (19) the said targets, and
- additional means for heating certain regions of the substrate, which consist of a pulsed laser (27).